(19) Europäisches Patentamt
European Patent Office
Office européen des brevets

(11) **EP 1 180 553 A1**

(12) **EUROPEAN PATENT APPLICATION**

(43) Date of publication:
**20.02.2002   Bulletin 2002/08**

(51) Int Cl.⁷: **C23C 16/18**, C23C 16/02,
H01L 21/285, H01L 21/768

(21) Application number: **01119547.6**

(22) Date of filing: **14.08.2001**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **15.08.2000   US 638586**

(71) Applicant: **AIR PRODUCTS AND CHEMICALS,
INC.**
**Allentown, PA 18195-1501 (US)**

(72) Inventors:
• **Beck, Scott Edward**
  **Kutztown, PA 19530 (US)**
• **Karwacki, Eugene Joseph, Jr.**
  **Orefield, PA 18069 (US)**
• **Ciotti, Ralph J.**
  **Schnecksville, PA 18078 (US)**
• **Norman, John Anthony Thomas**
  **Encinitas, CA 92024 (US)**

(74) Representative: **Kador & Partner**
**Corneliusstrasse 15**
**80469 München (DE)**

(54) **CVD process for depositing copper on a barrier layer**

(57)     A process is described for depositing a copper film on a substrate surface by chemical vapor deposition of at least one copper precursor. The process includes treating a diffusion barrier layer surface and/or a deposited film with a proton-donating molecule and/or a hydrogen-donating molecule. The donating molecule reduces positively charged copper to copper metal and reacts with fluorine on the barrier layer surface to produce volatile silicon fluoride, to thereby form a clean interfacial layer that promotes adhesion between the diffusion barrier layer and the copper film. The donating molecule is preferably methylsilane. The invention also encompasses a process for depositing a copper film on a surface of a diffusion barrier layer by chemical vapor deposition. The process includes: (a) depositing on the surface copper from a non-fluorinated copper precursor to form a continuous film containing copper; and (b) depositing on the continuous film copper from a fluorinated copper precursor. Processes of the invention provide copper-based films, wherein a texture of the copper-based films is predominantly (111). Such films provide substrates having enhanced adhesion between the diffusion barrier layer underlying the (111) film and the copper overlying the (111) film. Processes of the invention can include post-deposition annealing of the copper film.

EP 1 180 553 A1

**Description**

CROSS-REFERENCE TO RELATED APPLICATIONS

Not applicable.

STATEMENT REGARDING FEDERALLY SPONSORED RESEARCH OR DEVELOPMENT

Not applicable.

BACKGROUND OF THE INVENTION

This invention relates to a chemical vapor deposition process for depositing copper films on barrier layer materials, and more specifically, to improving adhesion between copper and barrier layers.

CVD (Chemical Vapor Deposition) is a superior process for producing microscopic metal features on substrates. In this technique, a volatile metal-organic compound in the gas phase is contacted with areas of a circuit where growth of a metal film (e.g., an interconnect) is required.

Copper films have previously been prepared via CVD using various copper precursors. One of the best known and most frequently used CVD copper precursors is the solid compound copper$^{+2}$ bis(hexafluoroacetylacetonate) (i. e., copper$^{+2}$ bis(hfac)). This highly fluorinated organometallic precursor is significantly more volatile than its parent unfluorinated complex, copper$^{+2}$ bis(acetylacetonate), and its ease of vaporization has made it a popular choice for CVD processes. The use of this compound as a general precursor for CVD copper metallization was first described by Van Hemert et al. in J. Electrochem. Soc. (112), 1123 (1965) and by Moshier et al. in U.S. Patent No. 3,356,527. More recently, Reisman et al. (J. Electrochemical Soc., Vol. 136, No. 11, November 1989) and Kaloyeros et al. (Journal of Electronic Materials, Vol. 19, No. 3, 271, 1990) in two independent studies evaluated the use of this compound as a copper precursor for electronics applications. In these studies, copper films were formed by contacting vapors of copper$^{+2}$(hfac)$_2$, mixed with either an inert gas (argon) or hydrogen and contacting the mixture with a heated substrate surface. In the case of using hydrogen, the copper$^{+2}$ atom in the precursor complex is formally reduced to copper metal, while the hfac$^{-1}$ ligand becomes protonated to yield a neutral volatile compound. In the case of using an inert gas, the copper$^{+2}$ (hfac)$_2$ is simply pyrolyzed to give copper metal and fragments of the hfac ligand.

Selective deposition of pure copper films by CVD at low temperatures onto metallic substrates using Cu$^{+1}$ (hfac)L complexes (where L is alkene or alkyne) has been described previously by Norman et al. in U.S. Patents Nos. 5,085,731, 5,094,701 and 5,098,516. Under certain conditions, blanket (non-selective) deposition can also be achieved using these precursors (Norman et al., E-MRS proc. B17 (1993) 87-92). A particularly effective CVD copper precursor is 1,1,1,5,5,5-hexafluoro-2,4-pentanedionatocopper (I) trimethylvinylsilane (hereinafter Cu(hfac)(TMVS)), which is sold under the trademark CupraSelect by the Schumacher unit of Air Products and Chemicals, Inc., Carlsbad, California.

As shown by the following equations, precursors such as Cu(hfac)(TMVS) function by a surface catalyzed disproportionation reaction to give a volatile Cu$^{+2}$ complex, free olefin and copper metal (wherein (s) denotes interaction with a surface and (g) denotes the gas phase):

$$2 \text{ Cu}^{+1}\text{hfacTMVS}_{(g)} \rightarrow 2 \text{ Cu}^{+1}\text{hfacTMVS}_{(s)} \tag{1}$$

$$2 \text{ Cu}^{+1}\text{hfacTMVS}_{(s)} \rightarrow 2 \text{ Cu}^{+1}\text{hfac}_{(s)} + 2 \text{ TMVS}_{(g)} \tag{2}$$

$$2 \text{ Cu}^{+1}\text{hfac}_{(s)} \rightarrow \text{Cu}_{(s)} + \text{Cu}^{+2}(\text{hfac})_{2(g)} \tag{3}$$

In Equation (1), the complex is adsorbed from the gas phase onto a metallic surface. In Equation (2), the coordinated olefin (TMVS in this example) dissociates from the complex as a free gas leaving behind Cu$^{+1}$hfac as an unstable compound. In Equation (3), the Cu$^{+1}$hfac disproportionates to yield copper metal and volatile Cu$^{+2}$(hfac)$_2$.

Despite the foregoing developments, the integrated circuit (IC) industry is presently experiencing difficulty forming adherent copper films on barrier layer materials such as Ta, TaN, TiN, etc., via chemical vapor deposition (CVD) with fluorinated precursors, including hfac-based precursors such as Cu(hfac)(TMVS). A variety of solutions to this problem have been proposed.

For example, Gandikota et al., 50 Microelectronic Engineering 547-53 (2000), purports to improve adhesion between a CVD copper thin film and barrier layers by: (a) depositing a copper flash layer on the barrier layer by physical vapor deposition (PVD) prior to chemical vapor deposition, or (b) annealing the CVD copper layer after deposition. Unfortunately, these methods are not acceptable to the IC industry because they add to the equipment requirements for the copper deposition step. In addition, annealing, particularly at elevated temperatures, can have deleterious effects on the overall product.

WO 00/03420 (Paranjpe et al.) discloses improving CVD copper adhesion to a diffusion barrier layer by: (a) annealing the seed layer deposited on the diffusion barrier layer surface, or (b) providing an inert seed layer (e.g., comprising a noble or passivated metal) on the diffusion barrier layer surface.

WO 99/63590 (Bhan et al.) discloses improving CVD copper adhesion to a diffusion barrier layer by: (a) providing a copper seed layer containing water on the diffusion barrier, and (b) annealing the seed layer with heat or ion bombardment.

U.S. Patent No. 5,909,637 to Charneski et al. discloses a copper CVD method comprising exposing a surface of a diffusion barrier layer to a reactive gas species to purportedly replace high-energy molecular bonds on the surface with low-energy bonds between the reactive gas species and the surface. This is said to change the surface characteristics of the exposed copper-receiving surface to promote the formation of bonds between the copper-receiving surface and copper subsequently deposited by CVD, whereby copper adhesion to the diffusion barrier is improved. The low-energy bonds are said to promote the adhesion of copper to the diffusion barrier layer.

U.S. Patent No. 5,913,144 to Nguyen et al. discloses a process for improving adhesion of CVD copper to barrier layers, comprising the steps of: exposing the copper-receiving surface to a reactive oxygen species; oxidizing a thin layer of the diffusion barrier material surface in response to the oxygen exposure; and stopping the exposure of the diffusion barrier material to the oxygen before the oxide layer exceeds approximately 30 angstroms, whereby the relatively thin oxide layer prepares the diffusion barrier material receiving surface for adhesion to copper.

U.S. Patent No. 5,918,150 to Nguyen et al. discloses the use of an inert gas to remove contaminating byproducts of the disproportionation reaction which deposits copper on the diffusion barrier layer. Low energy ions of the inert gas are impinged upon the contaminated copper layer to physically displace contaminants thereon and provide a clean copper surface for additional copper CVD.

U.S. Patent No. 5,948,467 to Nguyen et al. discloses a two-step deposition process, wherein the first step comprises copper CVD at a low deposition rate and the second step comprises copper CVD at a high deposition rate. The initial slow deposition rate is said to allow organic solvents within the precursor vapor to be carried out of the process chamber instead of being captured within the film at the interface between the diffusion barrier layer and overlying CVD copper. This is said to provide improved adhesion of CVD copper to the underlying diffusion barrier layer.

U.S. Patent No. 5,953,634 to Kajita et al. discloses a two-step deposition process, wherein the first step comprises copper CVD in the presence of an oxidizing gas and the second step comprises copper CVD in the absence of the oxidizing gas.

JP-A-10-98043 (Nguyen et al.) discloses a method for oxidizing the surface of the diffusion barrier layer to improve CVD copper adhesion thereto.

U.S. Patent No. 6,015,749 to Liu et al. discloses improving CVD copper adhesion to diffusion barrier layers by implanting germanium ions in a copper seed layer deposited on the diffusion barrier layer surface.

Despite the foregoing developments, there remains a need in the art for alternative solutions to the CVD copper adhesion problem.

All references cited herein are incorporated herein by reference in their entireties.

BRIEF SUMMARY OF THE INVENTION

Accordingly, the invention provides an improved copper CVD process, wherein the improvement comprises treating a diffusion barrier layer surface and/or a deposited film with a donating molecule selected from the group consisting of a proton-donating molecule and a hydrogen-donating molecule.

The invention also encompasses a process for depositing a copper film on a surface of a diffusion barrier layer by chemical vapor deposition, said process comprising: (a) depositing on the surface copper from a non-fluorinated copper precursor to form a continuous film containing copper; and then (b) depositing on the continuous film copper from a fluorinated copper precursor.

Processes of the invention provide copper-based films, wherein a texture of the copper-based films is predominantly (111) crystalline texture, as measured by X-ray Diffraction (XRD).

BRIEF DESCRIPTION OF SEVERAL VIEWS OF THE DRAWINGS

Not applicable.

DETAILED DESCRIPTION OF THE INVENTION

The invention improves upon conventional processes for depositing a copper film on a substrate surface by chemical vapor deposition of a copper precursor. In preferred embodiments, the inventive process comprises treating a diffusion barrier layer surface with a donating molecule selected from the group consisting of a proton-donating molecule and a hydrogen-donating molecule prior to and/or concurrent with depositing copper on the substrate.

The inventors have studied failed interfaces of CVD copper on tantalum, a typical barrier layer material, and found that the interface is littered with residual material and reaction byproducts, including $CF_x$, $CH_x$, TaC, $TaF_x$, $Ta_2O_5$, and hfac, from fluorinated copper precursors. If these materials are not removed from (or prevented from adhering to) the interfacial region, the overlying copper film will not adequately adhere to the substrate.

In particular, copper adhesion to barrier layers, such as tantalum, is impeded by the presence of a surface monolayer (or sub-monolayer) of metal fluoride. This fluoride forms because the barrier layer after deposition (via a physical process, such as sputtering, physical vapor deposition (PVD), ion metal plasma deposition (IMP), etc.) is chemically very reactive. The residual gases within the wafer handler and the copper CVD chamber contain byproducts from the copper deposition process. When fluorine containing molecules such as Cu(hfac)L complexes (where L is alkene or alkyne) or $Cu(hfac)_2$ are used for CVD of copper metal, the residual impurities can include organic fluorides, such as $H^+fac$. The high vacuum environment within the wafer handler contains sufficient levels of these impurities to cause the rapid formation of up to a surface monolayer of metal fluoride. In addition, other fluorocarbon impurities have been observed, which are probably associated with the surface decomposition of hfac residues. These fluorocarbons can either desorb from the surface when the wafer is heated for CVD, or further decompose and form more metal fluoride and carbidic-like residues on the surface that may also impede copper adhesion. Furthermore, during the initial stages of copper deposition reaction byproducts can react with the surface and be covered by copper.

In addition, another source of impurities in the CVD chamber is the precursor itself. The precursor reacts with the surface to form a surface-bound molecule that is not readily desorbed from the surface during conventional processes. Without wishing to be bound by any theories, it is believed that the surface-bound molecule is hfac having at least one fluorine removed therefrom, wherein the at least one fluorine reacts with the metal surface to form a metal fluoride.

Thus, it is preferred to provide a substrate surface, which is substantially free of fluorinated compounds. As used herein, the language "substantially free of X" where X is a material, such as fluorocarbons, metal halides or metal fluorides, is intended to denote that the material is not present or if it is present, the amount present is not large enough to alter adhesion of copper to the underlying diffusion barrier layer.

In embodiments, the diffusion barrier layer is maintained substantially free of undesirable materials by treating it with a proton-donating molecule or a hydrogen-donating molecule (i.e., a donating molecule) prior to commencing CVD of copper on the substrate. Treating the substrate in this way cleans the diffusion barrier layer surface of contaminants, such as fluorides of the metal of the diffusion barrier layer. If any of the residual precursor or deposition byproducts in the CVD chamber (e.g., from coating a preceding chip in an assembly line) becomes bound to the diffusion barrier layer and decomposes to form $TaF_x$, for example, the donating molecule of the invention will readily donate a hydrogen atom or proton to form HF. Because the substrate is being heated, the HF is then able to desorb from the barrier layer as a gas and be swept out of the CVD chamber, thereby providing a clean surface for copper deposition.

In addition, the donating molecule reduces positively charged copper species to copper metal.

This cleaning process provides a copper-containing film which is more strongly bound to the barrier layer surface, and better matched texturally. This matching is reflected in a XRD pattern for the copper film that more closely resembles the (111) texture obtained by PVD deposition on barrier layers and subsequent electroplating processes.

Thin films may exhibit a range of atomic order from amorphous to highly crystalline. A crystalline thin film may form as one single crystal with a specific crystallographic orientation relative to the substrate, or as an aggregate of crystals, with random or non-random orientations. XRD is capable of distinguishing highly oriented single crystals or polycrystalline films from polycrystalline films with random orientation. It has been shown that a copper film having (111) as the dominant texture or orientation is preferred because of its resistance to electromigration. Furthermore, it is widely accepted that copper deposited via a CVD process tends to form with a preference for a (200) texture on most commonly utilized barriers, such as tantalum, while copper deposited via a sputtering process on the same barrier films tends to orient with a preference for a (111) texture. The invention described herein not only improves the adhesion of copper but promotes the growth of copper films with a preference for a (111) texture.

In embodiments, the donating molecule is provided in the CVD chamber concurrently with the CVD precursor, so as to prevent the-formation of metal fluorides on the substrate and/or remove metal fluorides from the substrate as described above. Thus, the donating molecule treatment can be conducted before and/or during CVD copper deposition on the substrate. It is preferred to commence treatment of the diffusion barrier layer and CVD of the copper precursor simultaneously, and terminate the donating molecule treatment after a continuous film is provided on said surface, while continuing with copper CVD to allow for graded film formation.

The interfacial film (or primer coat) consists essentially of copper, is a continuous film, and is at least 5 angstroms (e.g., 5-600 angstroms) in thickness. In embodiments, the film further comprises silicon and at least one of the metal components that comprise the diffusion barrier layer. In embodiments wherein the donating molecule comprises germanium, the film further comprises germanium.

In embodiments, the continuous film is exposed to a hydrogen-based plasma or a gas containing hydrogen after terminating the treating with the donating molecule and before (and/or after) depositing copper on the continuous film by CVD, The atomic hydrogen produced in the plasma is used to reduce any oxide that is formed and to clean the surface of the continuous layer of contamination. The gas preferably consists essentially of at least 1% hydrogen and not more than 99% of at least one inert gas, such as Ar, He, Ne, Xe, Kr or $N_2$. Preferably, the continuous film is exposed to the gas at a temperature of at least the copper CVD deposition temperature.

The process of the invention is suitable for coating a variety of substrates. Preferably, the substrate surface to be coated (i.e., the diffusion barrier layer) comprises at least one member selected from the group consisting of tantalum, tantalum nitride, titanium, titanium nitride, tungsten and tungsten nitride. Tantalum and tantalum nitride are most preferred.

Preferred donating molecules include, e.g., at least one member selected from the group consisting of $H_2O$, $NH_3$, alanes, amines, stannanes, boranes and silanes. Additional preferred donating molecules include, e.g., at least one member selected from the group consisting of $SiH_4$; $SiH_x(CH_3)_{4-x}$, where x is from 1 to 4; boranes; $GeH_4$; $GeH_x(CH_3)_{4-x}$, where x is from 1 to 4; germylene; phenylgermane; $NH_3$; $N_2H_4$; $AsH_3$; $PH_3$; $SbH_3$; pyrazole; pyrazine; piperazine; imidazole; hexamethyleneimine; hexamethyldisilazane; non-fluorinated β-diketones; tetramethyl heptanedione; acetylacetone; and non-fluorinated β-diketoimines. Methylsilane and water are particularly preferred. It is also preferred that the donating molecule does not contain fluorine.

Co-deposition of the copper precursor with donating molecules is preferably terminated by stopping the flow of the donating molecules and purging at least a majority (i.e., > 50%) of the donating molecules from the reaction chamber. Purging can be accomplished by simultaneously: (a) optionally interrupting a flow of the copper precursor into the reaction chamber; (b) terminating a flow of the donating molecule into the reaction chamber; and (c) applying suction to the reaction chamber. Following purging, the flow rate of the copper precursor into the reaction chamber is increased to at least restore the flow rate of the copper precursor to its value prior to the purging.

In certain embodiments, the primer coat or strike layer can be formed using a non-fluorinated copper precursor such as copper(II) beta-diketonate complex or a non-fluorinated copper(II) silyl betadiketonate complex, more preferably $Cu(acetylacetone)_2$ or $Cu(tetramethyl\ heptanedione)_2$ and a hydrogen donating molecule. In other embodiments, the strike layer is deposited using only a non-fluorine containing precursor, and in still other embodiments, a fluorinated precursor and a hydrogen donating molecule are use to produce the strike layer. In embodiments employing a fluorinated precursor, the precursor is preferably a fluorinated organometallic compound, more preferably a compound comprising hexafluoroacetylacetonate, most preferably Cu(hfac)(TMVS).

In certain embodiments, the primer coat is provided by copper deposition conducted with a non-fluorinated copper precursor, and the bulk rate copper deposition is conducted with a fluorinated copper precursor. The initial rate of copper deposition by the non-fluorinated copper precursor is less than a bulk rate of copper deposition by the fluorinated copper precursor. In embodiments, the non-fluorinated copper precursor deposits a continuous film containing copper on the surface during treatment with the donating molecule. The fluorinated copper precursor deposits copper on the continuous film after donating molecule treatment is terminated.

Processes of the invention are preferably conducted at ambient pressure or less, more preferably at a pressure of about 10 torr to $10^{-10}$ torr. Processes of the invention can be conducted at temperatures below room temperature and at temperatures typically achieved during deposition of barrier layers (e.g., 200°C or more). Preferably, the processes are conducted at temperatures from 50-400°C, more preferably from 150-250°C for $Cu^I$ precursors and from 150-350°C for $Cu^{II}$ precursors when these precursors are used for bulk film deposition after the interfacial layer is formed. The invention provides copper-based films on diffusion barrier layers having a texture, which is predominantly (111). Such films provide enhanced adhesion between the underlying diffusion barrier layer and overlying copper.

A post-deposition annealing step is conducted in certain preferred embodiments. The term "annealing" as used herein means a post-deposition heat-treatment process. Annealing is preferably conducted in a reducing gas atmosphere (e.g., in hydrogen gas) or in an inert gas atmosphere (e.g., in an atmosphere of argon, nitrogen, helium, neon, krypton or xenon) and within a temperature range of 25 to 400°C. Annealing can be conducted for up to 2 hours, preferably up to 60 minutes.

The invention will be illustrated in more detail with reference to the following Examples, but it should be understood that the present invention is not deemed to be limited thereto.

EXAMPLES

The following procedure was used throughout the examples.

Copper is deposited on tantalum-coated wafers via chemical vapor deposition (CVD) in the manner described below. Since the tantalum was exposed to air, and thus had a native oxide, the oxide and any adventitious carbon is removed by light ion sputtering with argon ions before the CVD process (of course, in typical integrated systems, this sputtering step would not be necessary as the tantalum would not be exposed to air). This is performed in an ultra-high vacuum (UHV) chamber (base pressure was $10^{-10}$ Torr). The samples are analyzed via XPS in the UHV chamber to determine the extent of cleaning. Cleaning is complete when carbon and oxygen are not detected and the Ta(4f) region only reveals tantalum metal.

Incidentally, the inventors have analyzed sputtered samples before and after the sputtering process via atomic force microscopy and have not found a change in the surface roughness. These sputter-cleaned samples have surfaces similar to PVD, IMP, or sputter deposited barrier layer surfaces. Since the surface roughness does not change, the sputtering does not have a direct effect on the adhesion of the CVD copper.

After sputtering, the sample is transferred *in vacuo* to the CVD reactor. The sample is typically heated to the deposition temperature in an Ar ambient.

In the CVD reactor, the typical deposition conditions are: 190°C sample surface temperature, 1.5 Torr (0.03 Torr CVD chamber base pressure), and 40 sccm helium flowing through a bubbler of Cu(hfac)(tmvs) held at 40°C. All delivery lines and the walls of the CVD reactor are maintained at 60°C. Gas and vapor flow are first initiated into a bypass to stabilize flow before introducing these into the CVD reactor.

A conventional tape pull test (ASTM Standard D3359-95a, "Standard Test Method for Measuring Adhesion by Tape Test") is used to evaluate the adhesion of the films grown in the examples. The tape used in the examples was Permacel #99 tape.

Comparative Example

CVD copper films were deposited in accordance with the foregoing procedure. The maximum CVD copper film thickness produced in the above manner that adhered to the sputter-cleaned tantalum surface was approximately 1800 Å. Films having greater thicknesses delaminated. Films grown in the above manner had a mixed texture of (111) and (200) as determined by X-ray Diffraction (XRD) analysis.

Example 1: Deposition with Water

After transferring the sample into the CVD reactor under vacuum, a vapor draw of $H_2O$ was initiated into the CVD reactor for 10 seconds before introducing Cu(hfac)(tmvs). The total exposure to $H_2O$ was 70 seconds. The bulk copper film was grown under the same conditions as in the Comparative Example. A copper film of 14,560 Å was grown, which did not delaminate (100% adhesion). It should be noted that the copper film did not adhere to portions of the sample that were not sputtered. This is due to the difference in the chemistry of the tantalum and native oxide, air-exposed surfaces. Films grown in this manner had a predominance of (111) texture, with a small amount of (200) texture.

Example 2: Deposition with Methylsilane

The tantalum surface was sputter cleaned and the sample transferred in vacuo to the CVD reactor, as in the previous examples. The sample was heated to 190°C in an Ar ambient. An initial interfacial layer was formed during a one minute deposition in a methylsilane and Cu(hfac)(tmvs) ambient. After the first minute of deposition, the methylsilane flow was terminated and a bulk copper film was grown to a thickness of 7,000 Å. This film had 100% adhesion. Films grown in this manner had a predominance of (111) texture, with a small amount of (200) and (220) texture (see Table 1 below).

Table 1

| Example | Relative (111) Intensity | Relative (200) Intensity | Relative (220) Intensity |
|---|---|---|---|
| Comparative | 100 | 46.8 | 26.6 |
| 2 | 100 | $25.5 \pm 0.1$ | $15.5 \pm 0.5$ |

Films were also grown with initial methylsilane/Cu(hfac)(TMVS) co-depositions ranging from 30 seconds to 2 minutes. These films also had 100% adhesion.

Example 3: Deposition with Methylsilane Followed by Anneal

Films grown by the process described in Example 2 were annealed from 30 to 50 minutes in either Ar or 4% $H_2$/96% Ar between 250°C and 350°C. In all cases, these films continued to adhere when tested by either a Scotch tape method or the ASTM method referenced above. Furthermore, XRD analysis showed growth of copper films comprising a preferred (111) texture.

While the invention has been described in detail and with reference to specific examples thereof, it will be apparent to one skilled in the art that various changes and modifications can be made therein without departing from the spirit and scope thereof.

**Claims**

1.  In a process for depositing a copper film on a surface of a diffusion barrier layer by chemical vapor deposition of a copper precursor, the improvement comprising treating at least one of said surface and said copper film with a donating molecule selected from the group consisting of a proton-donating molecule and a hydrogen-donating molecule.

2.  The process of claim 1, wherein said treating is conducted prior to said chemical vapor deposition of said copper precursor.

3.  The process of claim 2, wherein said treating is further conducted during said chemical vapor deposition of said copper precursor.

4.  The process of claim 1, wherein said treating is conducted during said chemical vapor deposition of said copper precursor.

5.  The process of claim 1, wherein said treating and said chemical vapor deposition of said copper precursor commence simultaneously, and said treating is terminated after a continuous film is provided on said surface.

6.  The process of claim 5, wherein said diffusion barrier layer comprises at least one member selected from the group consisting of tantalum, tantalum nitride, titanium, titanium nitride, tungsten and tungsten nitride, and wherein said continuous film consists essentially of copper, silicon and said at least one member.

7.  The process of claim 5, wherein said chemical vapor deposition of said copper precursor is further conducted after terminating said treating.

8.  The process of claim 7, further comprising exposing said continuous film to a gas containing hydrogen after terminating said treating and before further conducting said chemical vapor deposition of said copper precursor.

9.  The process of claim 8, wherein said gas consists essentially of at least 1 % hydrogen and not more than 99% of at least one inert gas.

10. The process of claim 7, further comprising exposing said continuous film to a hydrogen-based plasma after terminating said treating and before further conducting said chemical vapor deposition of said copper precursor, wherein said hydrogen-based plasma is produced from a gas containing at least one inert gas and at least one of $H_2$, $NH_3$ and $N_2H_2$.

11. The process of claim 7, wherein said treating and said chemical vapor deposition of said copper precursor are conducted in a reaction chamber, and wherein at least a majority of said donating molecule is purged from said reaction chamber in conjunction with terminating said treating.

12. The process of claim 11, wherein said purging comprises simultaneously: (a) optionally interrupting a flow of said copper precursor into said reaction chamber; (b) terminating a flow of said donating molecule into said reaction chamber; and (c) applying suction to said reaction chamber.

13. The process of claim 12, wherein after said purging, a flow rate of said copper precursor into said reaction chamber is increased to at least restore said flow rate to its value prior to said purging.

14. The process of claim 1, wherein said donating molecule is at least one member selected from the group consisting of $H_2O$, $H_2O_2$, $NH_3$, alanes, amines, stannanes, boranes and silanes.

15. The process of claim 1, wherein said donating molecule is at least one member selected from the group consisting of $SiH_4$; $SiH_x(CH_3)_{4-x}$, where x is from 1 to 4; boranes; $GeH_4$; $GeH_x(CH_3)_{4-x}$, where x is from 1 to 4; germylene; phenylgermane; $NH_3$; $N_2H_4$; $AsH_3$; $PH_3$; $SbH_3$; pyrazole; pyrazine; piperazine; imidazole; hexamethyleneimine; hexamethyldisilazane; non-fluorinated beta-diketones; tetramethyl heptanedione; acetylacetone; and non-fluorinated beta-diketoimines.

16. The process of claim 1, wherein said copper precursor is a fluorinated organometallic compound.

17. The process of claim 1, wherein said copper precursor comprises hexafluoroacetylacetonate.

18. The process of claim 1, wherein said copper precursor is 1,1,1,5,5,5-hexafluoro-2,4-pentanedionato-copper (I) trimethylvinylsilane.

19. The process of claim 1, wherein a non-fluorinated copper precursor different from said donating molecule and said copper precursor deposits a continuous film containing copper on said surface during said treating, and said copper precursor deposits copper on said continuous film after said treating is terminated, and wherein an initial rate of copper deposition during said treating is less than a bulk rate of copper deposition after said treating is terminated.

20. The process of claim 19, wherein said non-fluorinated copper precursor is a non-fluorinated copper(II) beta-diketonate complex or a non-fluorinated copper(II) silyl beta-diketonate complex.

21. The process of claim 19, wherein said non-fluorinated copper precursor is Cu(acetylacetone)$_2$ or Cu(tetramethyl heptanedione)$_2$.

22. The process of claim 19, further comprising exposing said continuous film to a gas containing at least 1% hydrogen and not more than 99% of at least one inert gas, after terminating said treating and before depositing copper from said copper precursor on said continuous film.

23. The process of claim 19, further comprising exposing said continuous film to a hydrogen-based plasma after terminating said treating and before depositing copper from said copper precursor on said continuous film, wherein said hydrogen-based plasma is produced from a gas containing at least one inert gas and at least one of $H_2$, $NH_3$ and $N_2H_2$.

24. A process for depositing a copper film on a surface of a diffusion barrier layer by chemical vapor deposition, said process comprising:

    depositing on said surface copper from a non-fluorinated copper precursor to form a continuous film containing copper; and
    depositing on said continuous film copper from a fluorinated copper precursor.

25. The process of claim 1, wherein said copper film is annealed at a temperature of 25 to 400°C in an inert atmosphere comprising at least one inert gas selected from the group consisting of argon, nitrogen, helium, neon, krypton and xenon, or in a reducing atmosphere comprising hydrogen or a mixture of hydrogen and at least one said inert gas.

26. The process of claim 1, wherein said copper film is annealed from 30 to 50 minutes at 250°C to 350°C in an atmosphere containing at least 96 to 100% Ar and 4 to 0% $H_2$.

27. The process of claim 1, wherein said donating molecule reduces positively charged copper to copper metal and reacts with fluorine on said surface to produce volatile silicon fluoride, to thereby form an interfacial layer that promotes adhesion between said diffusion barrier layer and said copper film, said interfacial layer having a predominantly (111) texture.

28. The process of claim 5, wherein said diffusion barrier layer comprises at least one member selected from the group consisting of tantalum, tantalum nitride, titanium, titanium nitride, tungsten and tungsten nitride, and wherein said continuous film consists essentially of copper, germanium and said at least one member.

**29.** The process of claim 7, further comprising exposing said continuous film to a gas containing hydrogen after terminating said chemical vapor deposition of said copper precursor.

EP 1 180 553 A1

## EUROPEAN SEARCH REPORT

**European Patent Office**

**Application Number**

EP 01 11 9547

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br>A | US 5 744 192 A (SENZAKI YOSHIHIDE ET AL)<br>28 April 1998 (1998-04-28)<br>* claims *<br>--- | 1,4,14,<br>16-18,27<br>24 | C23C16/18<br>C23C16/02<br>H01L21/285<br>H01L21/768 |
| X,D | WO 99 63590 A (APPLIED MATERIALS INC)<br>9 December 1999 (1999-12-09) | 1,4-8,<br>10,11,<br>14,<br>16-18,27 | |
| A | * page 7, line 10 - page 9, line 28 *<br>--- | 24 | |
| A | EP 0 297 348 A (IBM)<br>4 January 1989 (1989-01-04)<br>* examples IV-VI *<br>------ | 24 | |

|  |  |  | TECHNICAL FIELDS<br>SEARCHED (Int.Cl.7)<br><br>C23C |

The present search report has been drawn up for all claims

| Place of search | Date of completion of the search | Examiner |
|---|---|---|
| THE HAGUE | 5 December 2001 | Patterson, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

European Patent
Office

Application Number

EP 01 11 9547

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent**
**Office**

**LACK OF UNITY OF INVENTION**
**SHEET B**

Application Number

EP 01 11 9547

The Search Division considers that the present European patent application does not comply with the requirements of unity of invention and relates to several inventions or groups of inventions, namely:

1. Claims: 1-23 25-29

    Method for depositing copper on a barrier layer involving treating the surface with hydrogen- or proton-donating reagents.

2. Claim : 24

    Method for depositing copper on a barrier layer by changing from one type of copper precursor to another.

**EP 1 180 553 A1**

**ANNEX TO THE EUROPEAN SEARCH REPORT
ON EUROPEAN PATENT APPLICATION NO.**                 EP 01 11 9547

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2001

| Patent document cited in search report | | Publication date | Patent family member(s) | | Publication date |
|---|---|---|---|---|---|
| US 5744192 | A | 28-04-1998 | JP | 10140352 A | 26-05-1998 |
| WO 9963590 | A | 09-12-1999 | US | 6319728 B1 | 20-11-2001 |
| | | | EP | 1084513 A1 | 21-03-2001 |
| | | | WO | 9963590 A1 | 09-12-1999 |
| EP 0297348 | A | 04-01-1989 | AU | 609493 B2 | 02-05-1991 |
| | | | AU | 1850388 A | 05-01-1989 |
| | | | CA | 1332036 A1 | 20-09-1994 |
| | | | DE | 3868724 D1 | 09-04-1992 |
| | | | EP | 0297348 A1 | 04-01-1989 |
| | | | ES | 2030109 T3 | 16-10-1992 |
| | | | JP | 1011975 A | 17-01-1989 |
| | | | JP | 1902412 C | 08-02-1995 |
| | | | JP | 6027327 B | 13-04-1994 |
| | | | US | 4948623 A | 14-08-1990 |

EPO FORM P0459

For more details about this annex : see Official Journal of the European Patent Office, No. 12/82

13